# EUROPEAN PATENT APPLICATION

(11) **EP 2 230 633 A1**
(43) Date of publication of application: **22.09.2010**
(21) Application number: 09305240.5
(22) Date of filing: 17.03.2009
(51) Int. Cl.: G06N 3/063, H01L 51/00

(54) **Neural network circuit comprising nanoscale synapses and CMOS neurons**

(71) Applicant: Commissariat à l'Énergie Atomique et aux Énergies Alternatives, 75015 Paris (FR)
(72) Inventor: Zhao, Weisheng, 91300 Massy-Palaiseau (FR); Agnus, Guillaume, 78210 Saint-Cyr L'Ecole (FR); Bourgoin, Jean-Philippe, 78960 Voisins Le Bretonneux (FR); Derycke, Vincent, 78180 Montigny Le Bretonneux (FR); Gamrat, Christian, 91940 Les Ulis (FR)
(74) Representative: Lucas, Laurent Jacques

(57) **Abstract**

The invention relates to a neural network circuit comprising nanoscale devices (411-415, 421-425) acting as synapses and CMOS circuits (201, 202) acting as neurons. It finds a particular interest for computing circuits and systems involving complex functions or handling of huge amounts of data. Comparing with the existing proposals, this architecture promises small die area, high speed thanks to massively parallel learning and low power.

The nanoscale devices (411-415, 421-425) comprise two terminals and are connected to row conductors (221, 222) and to column conductors (231-235) in a matrix-like fashion. A CMOS circuit (201, 202) is connected at one end of each row conductor (221, 222). An electrical characteristic between the two terminals of each nanoscale device (411-415, 421-425) is able to be modified by a signal applied to the second terminal. The neural network further comprises, for each row conductor (221, 222), means (401, 402) for preventing the electrical characteristics of the nanoscale devices (411-415, 421-425) connected to the considered row conductor (221, 222) from being modified by a signal applied to the second terminal of said nanoscale devices.

## Description

The invention relates to a neural network circuit comprising nanoscale devices acting as synapses and CMOS circuits acting as neurons. It finds a particular interest for computing circuits and systems involving complex functions or handling of huge amounts of data.

For at least three decades, Complementary Metal-Oxyde Semiconductor (CMOS) technology has been the dominant technology for Integrated Circuits (ICs) and computing systems. This is mainly due to its increasing performances in terms of area, power and speed, as described by the Moore's law. Most advanced IC chips are currently based on 32-nanometres (nm) CMOS nodes and can contain more than two billion transistors each. A single IC chip thus allows performing complex functions. However, the development of embedded devices, together with the demand for more and more complex functions, should lead to integrate even further transistors on IC chips. Nevertheless, the miniaturization of CMOS ICs is limited down to 11-nm nodes because of physical barriers such as quantum effects. Indeed, below this size, the Boolean computing can no more be applied due to high leakage currents. As a consequence, the difference between the "ON state" and the "OFF state" shrinks. Another consequence of the leakage currents is obviously the impact on the power performances of CMOS circuits. This greatly limits the standby time of embedded devices and, in practice, their functionalities. If the quantum effects are a substantial issue for 11-nm nodes, they are already significant in terms of static performances for ICs based on 90-nm CMOS nodes.

In this context, nanometre scale components, also called "nanoscale components" or "nanocomponents", are viewed as a possible way to go beyond the Moore's law. More particularly, nano building block above a CMOS circuit is considered as one of the most promising computing architectures to develop the new generation of circuits and systems. Such an architecture comprises a CMOS circuit on which is implemented a so-called "nano building block" or "nano-computing core" composed of nanoscale components. A contact array allows the nano building block to be connected vertically with the CMOS circuit. Although the nano building blocks above CMOS circuits promise higher function density than conventional CMOS circuits, they give raise to new difficulties. One of them is to control individually the nanocomponents in the nano building block. Another difficulty is to adapt the Boolean computing to the mismatch variations between the nanocomponents. For example, there can be up to 50% variation between two adjacent nanocomponents.

In order to make possible the implementation of nanocomponents with CMOS circuits, research is currently focused on the use of neural network principles. A nano building block, containing nanocomponents acting as synapses, is implemented on a CMOS circuit comprising components acting as neurons. This neural network circuit promises a high potential to overcome the intrinsic drawbacks of both the nanotechnology and the CMOS technology. It promises to make possible the implementation of some powerful functions such as classifier, associative storage etc., which cannot be easily implemented with conventional CMOS circuits. Some neural network circuits have been proposed. An example is described in patent US 7,359,888 of G. Snider. However, the current neural network circuits require complex CMOS circuits to control the function learning. Therefore, they still suffer from size and power issues and cannot provide higher performances than the existing CMOS circuits. Another limitation with current neural network circuits is that the learning of the different functions by the synapses can be very long, especially when the number of synapses per neuron is important, for example superior to 1000.

The present invention aims at providing an integrated circuit which can be used to overcome at least some of the drawbacks described above. The invention so proposes a neural network circuit comprising nanoscale devices acting as synapses, CMOS circuits acting as neurons, row conductors and column conductors. A CMOS circuit is connected at one end of each row conductor. Each nanoscale device comprises two terminals, a first terminal being connected to one of the row conductors and a second terminal being connected to one of the column conductors. An electrical characteristic between the two terminals of each nanoscale device can be modified by a signal applied to the second terminal of the considered nanoscale device. The neural network further comprises, for each row conductor, means for preventing the electrical characteristics of the nanoscale devices connected to the considered row conductor from being modified by a signal applied to the second terminal of said nanoscale devices.

In one embodiment, each nanoscale device comprises a memristor including two terminals. The terminals form the first and second terminals of the nanoscale device.
According to this embodiment, each means for preventing the electrical characteristics of the nanoscale devices from being modified comprises a current comparator and a control circuit, which form part of the corresponding CMOS circuit. Each current comparator comprises a first input connected to the corresponding row conductor, a second input receiving a reference current and an output connected to an input of the corresponding control circuit. Each control circuit comprises an output connected to the corresponding row conductor.

According to another embodiment of the invention, each nanoscale device comprises a carbon nanotube field-effect transistor, a source and a drain of each carbon nanotube field-effect transistor forming respectively the first and the second terminal of the considered nanoscale device. A resistance between the source and the drain can be modified by voltage pulses applied to the drain. The means for preventing the electrical characteristics of the nanoscale devices from being modified comprise as many enabling rows as row conductors, the gates of the carbon nanotube field-effect transistors connected to a given row conductor being connected to the associated enabling row.
According to this last embodiment, the carbon nanotube field-effect transistors can be optically gated, their resistances between the sources and the drains returning to an initial state by exposing them to a light beam at a given wavelength.
In addition, each means for preventing the electrical characteristics of the nanoscale devices from being modified further comprises a current comparator forming part of the corresponding CMOS circuit. Each current comparator comprises a first input connected to the corresponding row conductor, a second input receiving a reference current and an output connected to the corresponding enabling row.

Advantageously, the CMOS circuits form a first block and the nanoscale devices form a second block. The first block comprises a metal layer serving as a substrate for the second block.
In case the nanoscale devices comprise memristors, the metal layer can embody the column conductors. The neural network circuit can also comprise a further metal layer embodying the row conductors, the memristors being grown at each intersection of a column conductor and a row conductor.
In case the nanoscale devices comprise carbon nanotube field-effect transistors, the metal layer can embody the enabling rows. The neural network circuit can further comprise two metal layers, one of them embodying the row conductors and the other the column conductors, the carbon nanotube field-effect transistors being grown on the enabling rows at each intersection of a row conductor and a column conductor.

According to an embodiment of the invention, each nanoscale device comprises a graphene based tunable resistance including two terminals, the terminals forming the first and second terminals of the nanoscale device.

According to another embodiment of the invention, each nanoscale device comprises a nanoscale flash memory, a source and a drain of each nanoscale flash memory forming respectively the first and the second terminal of the considered nanoscale device. A resistance between the source and the drain can be modified by voltage pulses applied to the drain. The means for preventing the electrical characteristics of the nanoscale devices from being modified comprise as many enabling rows as row conductors, the gates of the nanoscale flash memories connected to a given row conductor being connected to an associated enabling row.

According to another embodiment of the invention, each nanoscale device comprises a graphene based field-effect transistor, a source and a drain of each graphene based field-effect transistor forming respectively the first and the second terminal of the considered nanoscale device. A resistance between the source and the drain can be modified by voltage pulses applied to the drain. The means for preventing the electrical characteristics of the nanoscale devices from being modified comprise as many enabling rows as row conductors, the gates of the graphene based field-effect transistors connected to a given row conductor being connected to an associated enabling row.

One of the advantages of the invention is that it permits high density of components due to the use of nanoscale devices. In particular, more than some billion of nanocomponents can be easily integrated in a nano building block since the size of each individual nanocomponent is about a few tens of nanometres. In addition, the nano building block can be implemented over the CMOS circuit. Thus, the final die area mainly depends on the surface of the CMOS circuit, which can be very small as it essentially contains the neuronal part of the circuit and the synapses are implemented above. In addition to the small die area, the high density allows complex functions to be implemented in the circuit. Another advantage of the invention is that all synapses can be updated in parallel, thus potentially reducing the learning duration in comparison with a sequential update. The means for preventing the electrical characteristics of the nanoscale devices from being updated also allow generalizing the input signals of the nodes for the learning of different functions. Since this arrangement only requires one set of voltage pulse generator, it reduces the die area of CMOS voltage pulse generator circuits. These means can also reduce the current passing between the two terminals of the nanoscale devices whose electrical characteristics have already been tuned and thereby promise low power consumption during the function learning. In addition, if the nanoscale devices are non-volatile, the circuit can work in low standby power during computing.

Other advantages and better understanding of the invention will appear from the following description taken into conjunction with the accompanying drawings, in which:
- figure 1 is a synoptic view of a node of a neural network circuit,
- figure 2 is a circuit diagram of a node of a neural network circuit according to prior art,
- figure 3 is a circuit diagram of a node of a neural network circuit according to a first embodiment of the invention,
- figure 4 is a circuit diagram of a node of a neural network circuit according to a second embodiment of the invention,
- figure 5 illustrates, in a perspective view, a possible implementation of carbon nanotube field-effect transistors,
- figure 6 illustrates the tuneable property of an optically-gated carbon nanotube field-effect transistor (OG-CNTFET),
- figure 7 illustrates the impact of the potential applied to the gate of an OG-CNTFET,
- figure 8 is a circuit diagram of a neural network circuit comprising two nodes, each node being connected to five OG-CNTFETs,
- figure 9 is a set of chronograms illustrating a first example of signals which can be applied to the sources or the drains of OG-CNTFETs of a neural network circuit,
- figure 10 is a set of chronograms illustrating a second example of signals which can be applied to the sources or the drains of OG-CNTFETs of a neural network circuit,
- figures 11 and 12 illustrate a possible implementation of a neural network circuit according to the first embodiment of the invention,
- figures 13 and 14 illustrate a possible implementation of a neural network circuit according to the second embodiment of the invention.

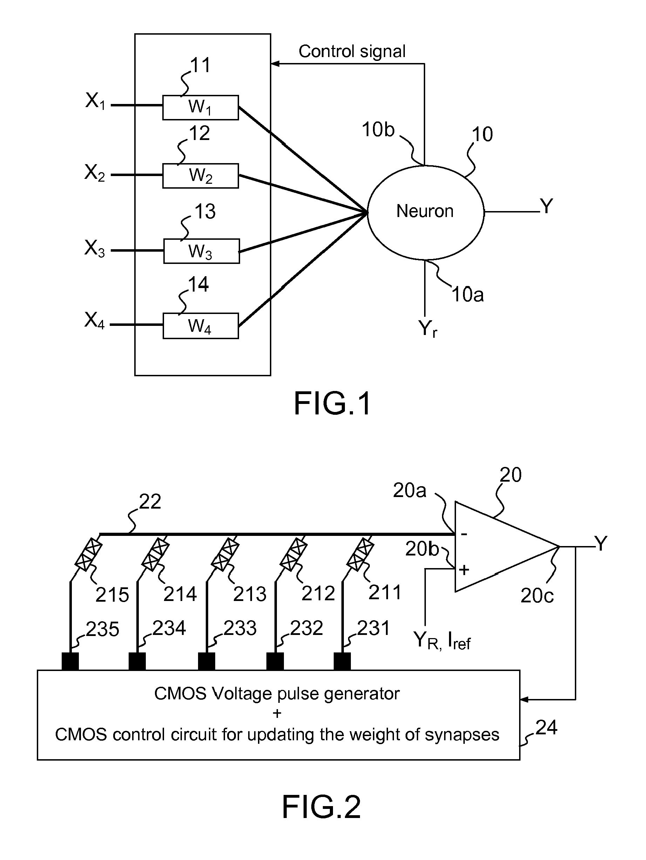

Figure 1 shows a generalised representation of a node of a neural network circuit. A node is the fundamental element of a neural network and essentially comprises two kinds of components, that is to say a neuron and a number of synapses. The neuron 10 of figure 1 is connected to four inputs X₁, X₂, X₃ and X₄ via four synapses 11, 12, 13, 14. Each synapse is characterized by a weight wᵢ which can take a real value, the subscript i being an integer designating the weight wᵢ of the synapse 1i associated with the corresponding input Xᵢ. The neuron 10 sums the weighted inputs X₁-X₄ and outputs a signal Y based on the amount of input signal received. A neuron is generally nonlinear in its output. It so contains an activation function that can take different forms according to the desired applications. The neuron 10 further comprises a reference input 10a and a control output 10b used for a learning phase. During this learning phase, sets of sample values are applied to the inputs X₁-X₄ and the resulting output signal Y for each set is compared to a reference signal Y_{R} applied to the reference input 10a. According to the result of each comparison, the weights wᵢ of the synapses 11-14 are updated until each output signal Y matches the reference signal Y_{R} associated with the corresponding set of sample values. Updating the synapses 11-14 is carried out by a control signal delivered by the control output 10b and applied individually to the synapses 11-14.

Figure 2 schematically illustrates a conventional node of a neural network circuit. It comprises a comparator 20, playing the role of a neuron, two-terminal components 211 to 215, playing the role of synapses, one row conductor 22, five column conductors 231 to 235 and a CMOS circuit 24. The row conductor 22 connects a first terminal of each two-terminal component 211-215 to a first input 20a of the comparator 20. A second input 20b of the comparator 20 can receive a reference signal Y_{R}. A second terminal of each two-terminal component 211-215 is individually connected to the CMOS circuit 24 through one of the column conductors 231-235. The comparator 20 can be carried out in CMOS technology and the two-terminal components 211-215 can be carried out in nanotechnology. In other words, the comparator 20 can be implemented with CMOS components and the two-terminal components 211-215 can be nanoscale devices. The resistance of the latter components can be variable and tuned according to the required weights wᵢ for the synapses. The tuning of the weights wᵢ so allows the node to perform a specific function. Indeed, if voltages are applied to column conductors 231-235, a current goes through each column conductor 231-235. The intensity of each current depends on the respective two-terminal component resistance. All currents of the column conductors 231-235 sum on the row conductor 22. Thus, the current on the row conductor 22 is dependent on the voltage applied to the column conductors 231-235 and on the two-terminal component resistances.
In a learning phase, that it is to say when the resistances (weights wᵢ) of the two-terminal components 211-215 (synapses) need to be tuned, sample voltages are applied to the column conductors 231-235 and the comparator 20 compares the resulting current on the row conductor 22 with a reference signal Y_{R}, here a reference current I_{ref}. According to the result of the comparison, that is to say according to the signal Y output by the comparator 20, the resistances of the two-terminal components 211-215 are adjusted individually.
As an example, we consider that the two-terminal components 211-215 are memristors. A memristor is a passive two-terminal circuit element that maintains a functional relationship between the time integrals of current and voltage. In particular, the resistance between the two terminals of a memristor can be modified by a voltage pulse applied between them. A memristor usually relies on nanotechnology. A more detailed description of a physical model of a memristor is given by D. B. Strukov, G. S. Snider, D. R. Stewart and R. S. Williams in "The missing memristor found", Nature, Vol. 453, pp. 80-83, 2008. Thus, in a learning phase, the resistances of the memristors 211-215 are adjusted through voltage pulses generated by the CMOS circuit 24. The amplitude and/or the number of voltage pulses on each column conductor 231-235 are set according to the resistance required for each memristor 211-215. This is achieved with a control circuit receiving the output signal Y from an output 20c of the comparator 20. This control circuit is carried out with CMOS technology and can be integrated into the CMOS circuit 24.
A neural network circuit comprising a node as described in reference with figure 2 can be easily achieved, even if the node comprises numerous memristors, for instance 1000 or more memristors per node. However, such a neural network requires one CMOS circuit 24 with a voltage pulse generator and a control circuit for each row of the neural network. Since the CMOS circuit 24 is relatively bulky in comparison with the memristors, the number of neurons that can be implemented in a neural network circuit remains limited. Thus, the performances, especially in terms of computing power, are not significantly better than the performances of neural network circuits implemented with full CMOS circuitry.

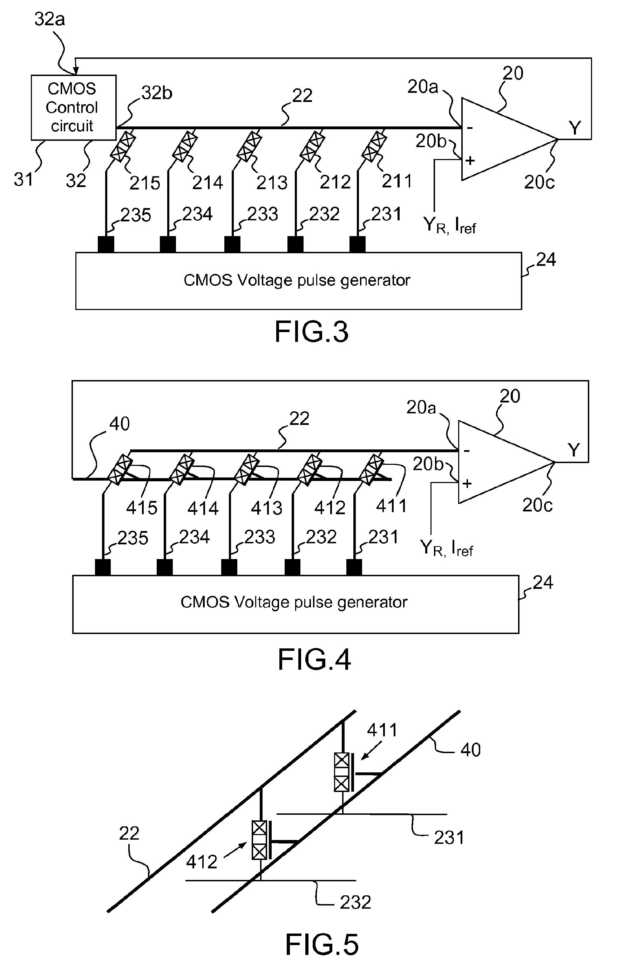

The present invention aims at providing a neural network circuit that fully exploits the density of nanoscale devices. Figure 3 illustrates a first embodiment of the invention with two-terminal nanoscale devices acting as synapses and CMOS circuits acting as neurons. More particularly, figure 3 illustrates one node of a neural network circuit. The node comprises a CMOS comparator 20 acting as a neuron and memristors 211 to 215 acting as synapses. The node as depicted in figure 3 mainly differs from the node of figure 2 in that it comprises means 31 for preventing the resistances of the memristors 211-215 connected to the comparator 20 from being modified when a voltage pulse is applied to the column conductors 231-235. These means 31 mainly comprise a control circuit 32, which includes an input 32a and an output 32b. The input 32a receives the output signal Y. The output 32b is connected to the row conductor 22. In a particular embodiment, the control circuit 32 is implemented with CMOS components. According to the invention, the CMOS circuit 24 of each node of the neural network circuit does not need control means associated with the voltage pulse generator. During the learning phase of a considered node, that is to say for all the time the node is learning a function, the control circuit 32 applies a determined potential on the corresponding row conductor 22. This potential may correspond to the ground or to the potential of the supply voltage. At the end of the learning phase of the considered node, the control circuit 32 can open the row conductor 22 so that the latter shows high impedance. This high impedance shields the memristors 211-215 from the effect of the voltage pulses generated by the CMOS circuit 24. As a consequence, no potential difference is seen by the memristors 211-215 when a voltage pulse is generated on the column conductors 231-235 and the resistances of the memristors 211-215 remain unchanged. As the row conductor 22 is open, no current can pass through it. Thus, no power is consumed by a node as soon as the corresponding function is learnt. This leads to a low power consumption.

Figure 4 illustrates a second embodiment of the invention. This second embodiment essentially differs from the embodiment illustrated in figure 3 in that the synapses are three-terminal nanoscale devices, for example carbon nanotube field-effect transistors (CNTFETs) 411 to 415. The source and the drain of each CNTFET are respectively connected to the row conductor 22 and to one of the column conductors 231-235. With this embodiment, the resistances R_{DS} between the source and the drain of each CNTFET 411-415 embody the weights wi of the synapses. The CMOS circuit 24 still does not need control means associated with the voltage pulse generator. Instead, the third terminal, that is to say the gate, of each CNTFET 411-415 is used to enable or not the change of resistance R_{DS} when a voltage pulse is generated on the column conductors 231-235. For this purpose, the node illustrated on figure 4 further comprises an enabling row 40 connecting the third terminals of all CNTFETs of the node to the output 20c of the comparator 20. This second embodiment is particularly advantageous since a node does not require any further control circuit. Indeed, the output signal Y can directly control the state of the CNTFETs of the node.

Figure 5 illustrates, in a perspective view, a possible implementation of the CNTFETs and, more particularly, their connection to the row conductor, the column conductors and the enabling row. This figure represents only two CNTFETs 411 and 412 respectively connected to column conductors 231 and 232. Obviously, the invention is dedicated to include any number of nanoscale devices. As can be seen on figure 5, the column conductors 231 and 232 lie on a first plane, the enabling raw 40 lies on a second plane and the row conductor 22 lies on a third plane, the CNTFETs 411 and 412 being implemented between the first and third planes.

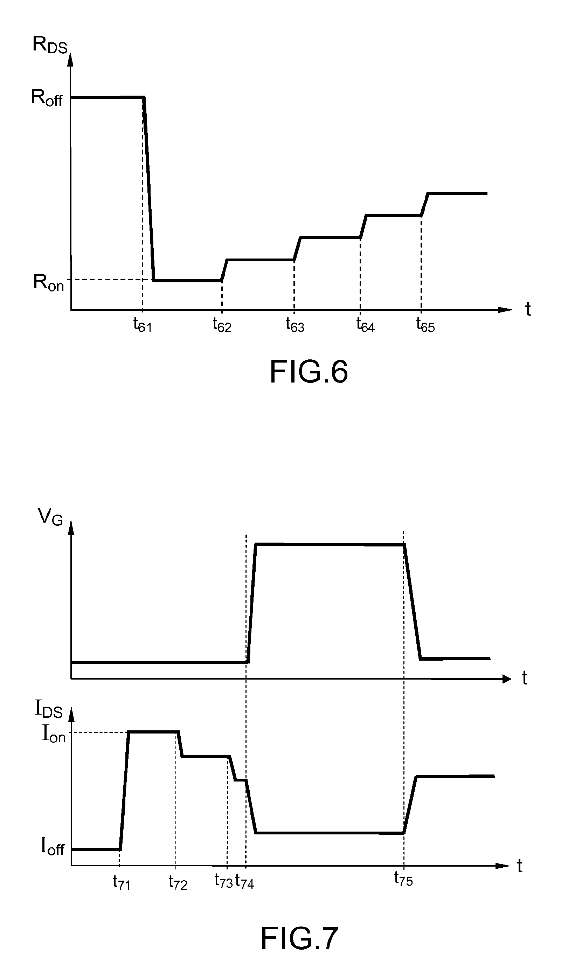

In a preferred embodiment of the invention, the CNTFETs are optically gated. Such transistors, abbreviated as OG-CNTFET, are for example described in patent US 7,323,730, issued on January 29, 2008. An OG-CNTFET can be considered as having four terminals in the meaning that it comprises, in addition to the three physical terminals of a conventional transistor, a "gate" sensible to light at a given wavelength and allowing modifying the electrical characteristics of this transistor. This gate is so called an "optical gate". Figure 6 shows the electrical characteristic change of an OG-CNTFET when voltage pulses are applied on the drain or on the source of the transistor, the gate of the OG-CNTFET being at a null or roughly null potential. The resistance R_{DS} between the source and the drain is plotted against time. The resistance R_{DS} can vary between a maximum magnitude, referred to as R_{off}, and a minimum magnitude, referred to as Rₒₙ. At the origin of the plot, the resistance R_{DS} is considered as being R_{off}. At an instant t₆₁, the optical gate of the transistor is exposed to a light beam at a wavelength it is sensible. As a consequence, the resistance R_{DS} drops down from R_{off} to Rₒₙ. At an instant t₆₂, a first voltage pulse is applied either on the source or on the drain of the transistor. This leads to an increase of the resistance R_{DS}. Similarly, at instants t₆₃, t₆₄ and t₆₅, voltage pulses are applied. Each voltage pulse implies an increase of the resistance R_{DS}. The resistance R_{DS} can so be adjusted step by step to roughly any resistance value comprised between R_{off} and Rₒₙ.

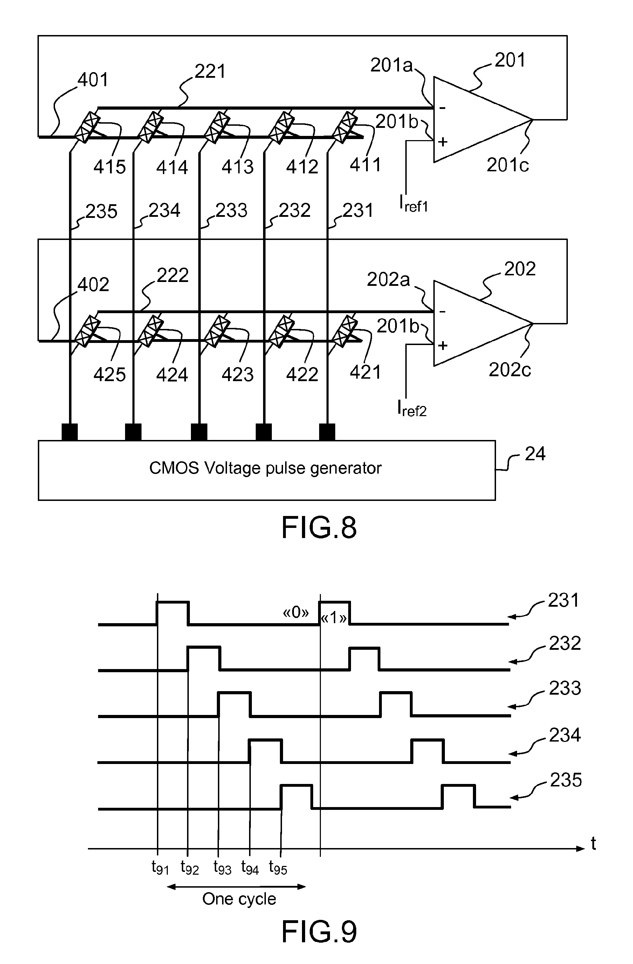

Figure 7 illustrates the impact of the potential applied to the gate of an OG-CNTFET. It represents the electrical characteristic behaviour of the OG-CNTFET in case a roughly null potential is applied to the gate and in case a no null potential is applied to the gate. The current I_{DS} passing between the drain and the source is plotted against time and varies between I_{off} and Iₒₙ, which are the currents for R_{off} and Rₒₙ, respectively. At the origin of the plot, the current I_{DS} is at level I_{off} and the potential V_{G} applied to the gate of the OG-CNTFET is approximately null, that is to say at the ground potential. At an instant t₇₁, the optical gate of the transistor is exposed to a light beam of appropriate wavelength. As a consequence, the resistance R_{DS} drops down from R_{off} to Rₒₙ and so the current I_{DS} rises from I_{off} to Iₒₙ. At an instant t₇₂, a first voltage pulse is applied either on the source or on the drain of the transistor. This leads to an increase of the resistance R_{DS} and so to a decrease of the current I_{DS}. Similarly, at an instant t₇₃, a second voltage pulse is applied, leading to a new decrease of the current I_{DS}. At an instant t₇₄, the gate of the transistor is led to a potential different from zero. It results in a reversible increase of the resistance R_{DS} and so in a decrease of the current I_{DS} for all the time a potential different from zero is applied to the gate, in this case between the instants t₇₄ and t₇₅. When the potential of the gate returns to approximately zero at instant t₇₅, the resistance R_{DS} recovers the value it has just before the raise of the gate potential at instant t₇₄. For all the time a potential different from zero is applied to the gate, the resistance R_{DS} cannot be changed by voltage pulses applied on the source or on the drain of the transistor. In other words, the resistance R_{DS} necessarily recovers the value it has just before instant t₇₄ whether or not voltage pulses had been applied between instants t₇₄ and t₇₅. Besides, the decrease of the current I_{DS} during this period of time shows an interest in terms of power consumption with neural network circuits comprising several nodes, as illustrated in figure 8.

The embodiments of figures 3 and 4 are especially profitable for neural network circuits comprising numerous nodes. Indeed, the second terminals of the nanoscale devices 211-215 or 411-415 can be connected to common column conductors 231-235. The nanoscale devices 211-215 or 411-415 are so arranged in a matrix-like array. A row of the matrix-like array is composed of a neuron and a number of nanoscale devices connected to the neuron through a row conductor. A column of the matrix-like array corresponds to a set of nanoscale devices connected to a column conductor. Then, only a single CMOS circuit 24 is necessary to modify the resistances of the nanoscale devices of all rows of the neural network circuit, while the nanoscale devices of all rows whose resistance do not need to be tuned can be protected from the effects of voltage pulses applied to the column conductors. The neural network circuit forms a matrix array. Nevertheless, the matrix does not necessarily comprise a nanoscale device at the intersection of each row with each column.
Figure 8 illustrates a neural network circuit comprising an array of OG-CNTFETs. On this figure is represented a 2x5 matrix but the neural network circuit according to the invention is particularly well adapted for matrices of thousands by thousands nanoscale devices. In addition, the OG-CNTFETs could also be any nanoscale devices with a variable resistance. In particular, these nanoscale devices can be two- or three-terminal nanoscale devices or a mix of two- and/or three-terminal nanoscale devices. The neural network circuit of figure 8 comprises two comparators 201 and 202 and two rows of OG-CNTFETs 411, 412, 413, 414 and 415, and 421, 422, 423, 424 and 425, respectively. A first input 201a of the comparator 201 is connected through a row conductor 221 to all first terminals of the OG-CNTFETs 411-415 of the first row. A second input 201b is able to receive a reference signal, for example a reference current I_{ref1}. Analogously, a first input 202a of the comparator 202 is connected through a row conductor 222 to all first terminals of the OG-CNTFETs 421-425 of the second row. A second input 202b is able to receive a reference signal, for example a reference current I_{ref2}. Each OG-CNTFET 411-415 and 421-425 of a row is connected individually to the CMOS circuit 24 via its second terminal and a column conductor 231-235. Each comparator 201 and 202 also comprises an output 201c and 202c connected to the third terminals of all OG-CNTFETs of the respective row through enabling rows 401 and 402, respectively. Such a neural network circuit allows generating a voltage pulse on several OG-CNTFETs at a time with a single voltage pulse generator thanks to a column conductor sharing. At the same time, the enabling rows 401 and 402 make possible to control the effect of voltage pulses on the OG-CNTFETs of each individual row. In other words, if a function is embodied by each node of the neural network circuit, the invention allows parallel function learning or parallel synaptic weight adjustments. The same voltage pulses are used for different neurons and the enabling rows 401 and 402 activate or deactivate the weight updating of synapses. A neural network circuit according to the invention allows simplifying significantly the CMOS control circuitry, in particular for complex computing systems involving more than one thousand synapses per neuron. Parallel function learning also implies a dramatic increase in the learning speed. More precisely, the learning duration for the whole neural network circuit should correspond to the learning duration of the node (function) requiring the most voltage pulses. The speed of function learning also depends on the duration and frequency of the voltage pulses. In a neural network circuit as described in reference with figure 8, all the OG-CNTFETs can share the same optical gate. Thus, the resistances of all the OG-CNTFETs can be reset at the same time from any state to the maximum resistance magnitude Rₒₙ. A light beam so allows initializing the synapses. Eventually, a neural network circuit according to the invention allows limiting the power consumption during the function learning phase. Indeed, when the resistances R_{DS} of the OG-CNTFETs of one node have been tuned so that the node performs the desired function, the enabling row 401 or 402 is led to a potential different from zero in order to shield the OG-CNTFETs 411-415 or 421-425 from the effect of voltage pulses generated on column conductors 231-235. As a result, the resistances R_{DS} of the considered OG-CNTFETs increase in a reversible manner and the current I_{DS} passing through these OG-CNTFETs is limited. Hence, a neural network circuit according to the invention may show low power consumption during the learning phase, that is to say the phase during which at least one node of the neural network circuit is learning a function. The power consumption saving is for example significant in case some functions are fast learnt and some others are learnt more slowly.

Figure 9 shows, by a set of chronograms, a first example of a train of voltage pulses which could be applied to column conductors of a neural network circuit according to the invention. Each chronogram illustrates voltage pulses applied to one of the column conductors 231-235. In particular, at an instant t₉₁, a first voltage pulse is applied to the column conductor 231. At the instant t₉₂, a first voltage pulse is applied to the column conductor 232. Voltage pulses are sequentially applied to the column conductors 231-235 at instants t₉₁ to t₉₅. In case of figure 9, a first voltage pulse is finally applied to the column conductor 235 at the instant t₉₅. All these voltage pulses constitute a first cycle. Successive cycles can be repeated. Hence, each nanoscale device can receive the number of voltage pulses required so that its resistance, taken into consideration with the resistances of the other nanoscale devices of the considered row, allows the neuron of said row to perform the desired function.

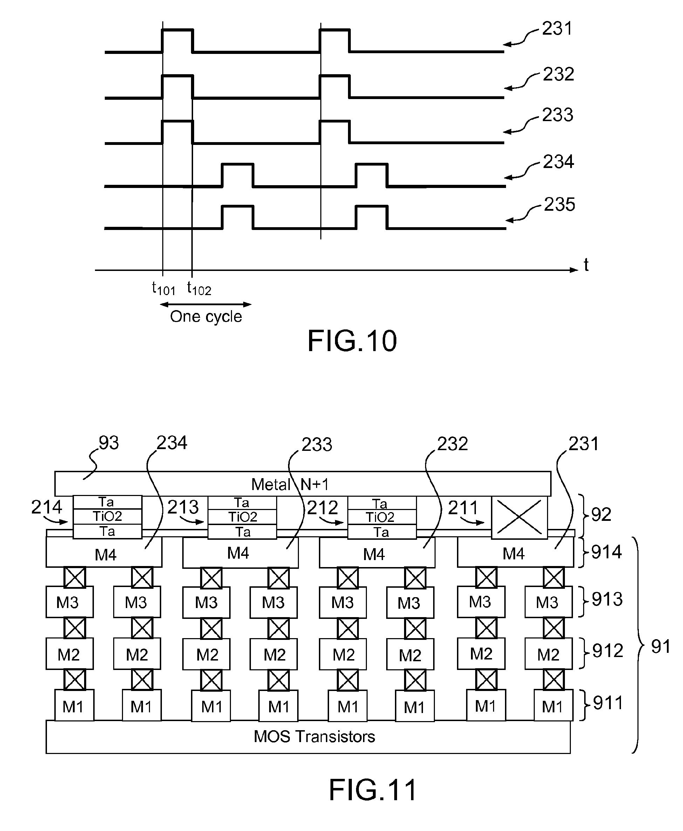

Figure 10 shows, by a set of chronograms, a second example of a train of voltage pulses which can be applied to column conductors of a neural network circuit according to the invention. Unlike the train of voltage pulses illustrated on figure 9, voltage pulses are applied to several column conductors at the same time. On the example of figure 10, a voltage pulse is applied at an instant t₁₀₁ to the column conductors 231, 232 and 233. At an instant t₁₀₂, a voltage pulse is applied to the column conductors 234 and 235. This example of train of voltage pulses corresponds to a partial parallel function learning. It leads, however, to a cycle duration which is significantly reduced in comparison with the duration of a sequential cycle as illustrated in figure 9. Note that, according to the invention, voltage pulses can be applied to all column conductors and thus, to all nanoscale devices, at the same time. Such a train of voltage pulses would so be referred to as a full parallel function learning. As a consequence, the duration of a cycle can be reduced to the duration of a single voltage pulse, thus reducing the function learning duration.

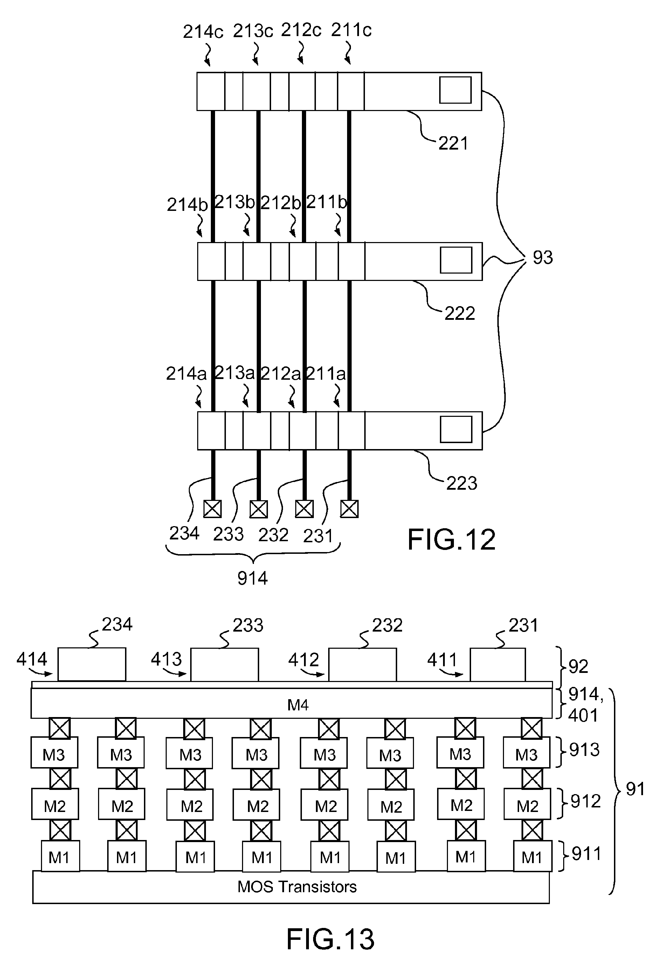

Figures 11 and 12 illustrate a possible implementation of a neural network circuit according to the invention and comprising two-terminal nanoscale devices. More particularly, they illustrate a 3x4 neural network circuit based on a nano building block implemented on a CMOS circuit. Figures 11 and 12 are respectively a schematic cross-section view and a schematic top view of this neural network circuit. The latter comprises a CMOS circuit 91 forming a first block and a nano building block 92 implemented on top of the CMOS circuit 91. The CMOS circuit 91 can incorporate a voltage pulse generator and, more generally, the CMOS circuit 24. The CMOS circuit 91 can also incorporate the comparators 20. It can be a multilayer printed circuit. In the embodiment of figure 11, it comprises four metal layers 911, 912, 913 and 914. The fourth metal layer 914 can serve as a substrate for the nano building block 92. In particular, the metal layer 914 can be designed so as to form the column conductors 231-234. Two-terminal nanoscale devices 211a-c, 212a-c, 213a-c and 214a-c can so be grown on the metal layer 914. In a particular embodiment of the invention, the nanoscale devices 211a-214c are memristors. Such nanoscale devices normally feature a vertical structure. Hence, if the nanoscale devices 211a-214c are arranged in a matrix-like array, as illustrated in figure 12, a further metal layer 93 can form row conductors 221, 222 and 223. For example, if the fourth metal layer 914 is more generally referred to as a M^{th} layer of the CMOS circuit 91, with M an integer, the further metal layer 93 can correspond to a (M+1)^{th} layer. The implementation of a neural network circuit according to figures 11 and 12 so shows a crossbar structure.

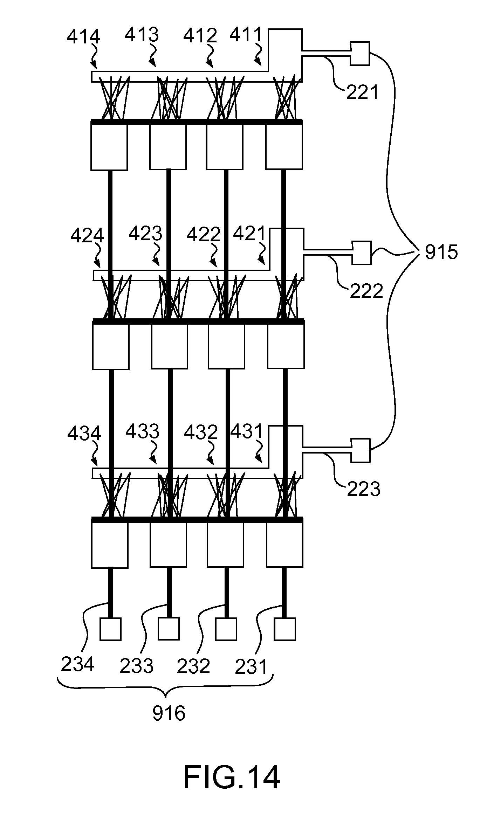

Figures 13 and 14 illustrate another possible implementation of a neural network circuit according to the invention. This implementation also comprises three nodes with four synapses per node, but the synapses are embodied by three-terminal nanoscale devices, for example CNTFETs. Figures 13 and 14 are respectively a schematic cross-section view and a schematic top view of the neural network circuit according to the second implementation. The neural network circuit also comprises a multilayer printed CMOS circuit 91 with four metal layers 911-914, the last of them serving as a substrate for the nano building block 92. In particular, the fourth metal layer 914 can be designed so as to embody enabling rows 401. Two further metal layers 915 and 916 can respectively embody row conductors 221-223 and column conductors 231-234. For example, if the fourth metal layer 914 is more generally referred to as a M^{th} layer of the CMOS circuit 91, with M an integer, the metal layers 915 and 916 can respectively correspond to a (M+1)^{th} layer and to a (M+2)^{th} layer. Carbon nanotubes are then grown on each enabling row 401 so as to form a CNTFET 411-414, 421-424 and 431-434 at each intersection of a row conductor 221-223 and a column conductor 231-234.

According to a third embodiment of the invention, each nanoscale device comprises a graphene based tunable resistance. Such a component is for example presented in Y. Li et al, "Electronic two-terminal bistable graphitic memories", Nature Material, Vol. 7, pp. 966-971, 2008, and in B. Standley et al, "Graphene-based atomic-scale switches", Nano Letters, Vol. 8, pp. 3345-3349, 2008. The component comprises two terminals which form the first and second terminals of the nanoscale device.

According to a fourth embodiment of the invention, each nanoscale device comprises a graphene based field-effect transistor or GNRFET. Such a component is for example presented in X. Wang et al, "Room-Temperature All-Semiconducting Sub-10-nm Graphene Nanoribbon Field-Effect Transistors ", Physical Review Letters, Vol. 100, 206803, 2008. A source and a drain of each GNRFET can form respectively the first and second terminals of the nanoscale device. A resistance between the source and the drain can be modified by voltage pulses applied to the drain. According to this embodiment of the invention, the means for preventing the electrical characteristics of the nanoscale devices from being modified are similar to those for the CNTFETs. In other words, they comprise enabling rows 401-402, the gates of the GNRFETs connected to a given row conductor 221-223 being connected to the associated enabling row 401-402.

According to a fifth embodiment of the invention, each nanoscale device comprises a so called nanoscale flash memory, or nano flash memory. Such a component is for example presented in patents US 6,760,245, US 6,768,158 and US 2008/0055985 A1. A nano flash memory is a transistor-like component in the meaning that it comprises a source, a drain and a gate. The source and the drain of each nano flash memory can form respectively the first and second terminals of the nanoscale device. A resistance between the source and the drain can be modified by voltage pulses applied to the drain. According to this embodiment of the invention, the means for preventing the electrical characteristics of the nanoscale devices from being modified are similar to those for the CNTFETs.

## Claims

1. Neural network circuit **characterised in that** it comprises nanoscale devices (211-215, 411-415) acting as synapses (11-14), CMOS circuits (20, 201, 202) acting as neurons (10), row conductors (22, 221-223) and column conductors (231-235), a CMOS circuit (20, 201, 202) being connected at one end of each row conductor (22, 221-223), each nanoscale device (211-215, 411-415) comprising two terminals, a first terminal being connected to one of the row conductors (22, 221-223) and a second terminal being connected to one of the column conductors (231-235), an electrical characteristic (R_{DS}) between the two terminals of each nanoscale device (211-215, 411-415) being able to be modified by a signal applied to the second terminal of the considered nanoscale device, the neural network further comprising, for each row conductor (22, 221-223), means (31, 40) for preventing the electrical characteristics (R_{DS}) of the nanoscale devices (211-215, 411-415) connected to the considered row conductor (22, 221-223) from being modified by a signal applied to the second terminal of said nanoscale devices.

2. Neural network circuit according to claim 1, **characterised in that** each nanoscale device (211-215, 411-415) comprises a memristor (211-215) including two terminals, the terminals forming the first and second terminals of the nanoscale device.

3. Neural network circuit according to claim 2, **characterised in that** each means (31, 40) for preventing the electrical characteristics of the nanoscale devices (211-215) from being modified comprises a current comparator (20, 201, 202) and a control circuit (32) forming part of the corresponding CMOS circuit, each current comparator comprising a first input (20a, 201 a, 202a) connected to the corresponding row conductor (22, 221-223), a second input (20b, 201 b, 202b) receiving a reference current (I_{ref}) and an output (20c, 201 c, 202c) connected to an input (32a) of the corresponding control circuit (32), each control circuit comprising an output (32b) connected to the corresponding row conductor (22, 221-223),.

4. Neural network circuit according to claim 1, **characterised in that** each nanoscale device (211-215, 411-415) comprises a carbon nanotube field-effect transistor (411-415, 421-425), a source and a drain of each carbon nanotube field-effect transistor forming respectively the first and the second terminal of the considered nanoscale device, a resistance (R_{DS}) between the source and the drain being able to be modified by voltage pulses applied to the drain, the means (31, 40) for preventing the electrical characteristics (R_{DS}) of the nanoscale devices (211-215, 411-415) from being modified comprising as many enabling rows (40, 401, 402) as row conductors (22, 221-223), the gates of the carbon nanotube field-effect transistors (411-415, 421-425) connected to a given row conductor (22, 221-223) being connected to an associated enabling row (40, 401, 402).

5. Neural network circuit according to claim 4, **characterised in that** the carbon nanotube field-effect transistors (411-415, 421-425) are optically gated, their resistances (R_{DS}) between the sources and the drains returning to an initial state (Rₒₙ) by exposing them to a light beam at a given wavelength.

6. Neural network circuit according to claim 4 or 5, **characterised in that** each means (31, 40) for preventing the electrical characteristics (R_{DS}) of the nanoscale devices (211-215, 411-415) from being modified further comprises a current comparator (20, 201, 202) forming part of the corresponding CMOS circuit, each current comparator comprising a first input (20a, 201 a, 202a) connected to the corresponding row conductor (22, 221-223), a second input (20b, 201 b, 202b) receiving a reference current (I_{ref}, I_{ref1}, I_{ref2}) and an output (20c, 201 c, 202c) connected to the corresponding enabling row (40, 401, 402).

7. Neural network circuit according to any one of claims 1 to 6, **characterised in that** the CMOS circuits (20, 201, 202) form a first block (91) and the nanoscale devices (211-215, 411-415) form a second block (92), the first block (91) comprising a metal layer (914) serving as a substrate for the second block (92).

8. Neural network circuit according to claim 2 or 3 and to claim 7, **characterised in that** the metal layer (914) embodies the column conductors (231-234) and **in that** the neural network circuit comprises a further metal layer (93) embodying the row conductors (221-223), the memristors (211-215) being grown at each intersection of a column conductor (231-234) and a row conductor (221-223).

9. Neural network circuit according to any one of claims 4 to 6 and to claim 7, **characterised in that** the metal layer (914) embodies the enabling rows (40, 401, 402) and **in that** the neural network circuit further comprises two metal layers (915, 916), one of them embodying the row conductors (221-223) and the other the column conductors (231-234), the carbon nanotube field-effect transistors (411-415, 421-425) being implemented on the enabling rows (40, 401, 402) at each intersection of a row conductor (221-223) and a column conductor (231-234).

10. Neural network circuit according to claim 1, **characterised in that** each nanoscale device (211-215, 411-415) comprises a graphene based tunable resistance including two terminals, the terminals forming the first and second terminals of the nanoscale device.

11. Neural network circuit according to claim 1, **characterised in that** each nanoscale device (211-215, 411-415) comprises a nanoscale flash memory, a source and a drain of each nanoscale flash memory forming respectively the first and the second terminal of the considered nanoscale device, a resistance (R_{DS}) between the source and the drain being able to be modified by voltage pulses applied to the drain, the means (31, 40) for preventing the electrical characteristics (R_{DS}) of the nanoscale devices (211-215, 411-415) from being modified comprising as many enabling rows (40, 401, 402) as row conductors (22, 221-223), the gates of the nanoscale flash memories connected to a given row conductor (22, 221-223) being connected to an associated enabling row (40, 401, 402).

12. Neural network circuit according to claim 1, **characterised in that** each nanoscale device (211-215, 411-415) comprises a graphene based field-effect transistor, a source and a drain of each graphene based field-effect transistor forming respectively the first and the second terminal of the considered nanoscale device, a resistance (R_{DS}) between the source and the drain being able to be modified by voltage pulses applied to the drain, the means (31, 40) for preventing the electrical characteristics (R_{DS}) of the nanoscale devices (211-215, 411-415) from being modified comprising as many enabling rows (40, 401, 402) as row conductors (22, 221-223), the gates of the graphene based field-effect transistors connected to a given row conductor (22, 221-223) being connected to an associated enabling row (40, 401,402).

## Amended claims

### Amended claims in accordance with Rule 137(2) EPC.

**1.** Neural network circuit comprising nanoscale devices (211-215, 411-415) acting as synapses (11-14), CMOS circuits (20, 201, 202) acting as neurons (10), row conductors (22, 221-223) and column conductors (231-235), a CMOS circuit (20, 201, 202) being connected at one end of each row conductor (22, 221-223), each nanoscale device (211-215, 411-415) comprising two terminals, a first terminal being connected to one of the row conductors (22, 221-223) and a second terminal being connected to one of the column conductors (231-235), an electrical characteristic (R_{DS}) between the two terminals of each nanoscale device (211-215, 411-415) being able to be modified by a signal applied to the second terminal of the considered nanoscale device, the neural network being **characterised in that** it further comprises, for each row conductor (22, 221-223), means (31, 40) for preventing the electrical characteristics (R_{DS}) of the nanoscale devices (211-215, 411-415) connected to the considered row conductor (22, 221-223) from being modified by a signal applied to the second terminal of said nanoscale devices.

**2.** Neural network circuit according to claim 1, **characterised in that** each nanoscale device (211-215, 411-415) comprises a memristor (211-215) including two terminals, the terminals forming the first and second terminals of the nanoscale device.

**3.** Neural network circuit according to claim 2, **characterised in that** each means (31, 40) for preventing the electrical characteristics of the nanoscale devices (211-215) from being modified comprises a current comparator (20, 201, 202) and a control circuit (32) forming part of the corresponding CMOS circuit, each current comparator comprising a first input (20a, 201 a, 202a) connected to the corresponding row conductor (22, 221-223), a second input (20b, 201 b, 202b) receiving a reference current (I_{ref}) and an output (20c, 201 c, 202c) connected to an input (32a) of the corresponding control circuit (32), each control circuit comprising an output (32b) connected to the corresponding row conductor (22, 221-223), and applying a determined potential on the corresponding row conductor (22, 221-223) when the electrical characteristics of the nanoscale devices (211-215) need to be modified and opening said row conductor (22, 221-223) when the electrical characteristics of the nanoscale devices (211-215) do not need to be modified.

**4.** Neural network circuit according to claim 1, **characterised in that** each nanoscale device (211-215, 411-415) comprises a carbon nanotube field-effect transistor (411-415, 421-425), a source and a drain of each carbon nanotube field-effect transistor forming respectively the first and the second terminal of the considered nanoscale device, a resistance (R_{DS}) between the source and the drain being able to be modified by voltage pulses applied to the drain, the means (31, 40) for preventing the electrical characteristics (R_{DS}) of the nanoscale devices (211-215, 411-415) from being modified comprising as many enabling rows (40, 401, 402) as row conductors (22, 221-223), the gates of the carbon nanotube field-effect transistors (411-415, 421-425) connected to a given row conductor (22, 221-223) being connected to an associated enabling row (40, 401, 402).

**5.** Neural network circuit according to claim 4, **characterised in that** the carbon nanotube field-effect transistors (411-415, 421-425) are optically gated, their resistances (R_{DS}) between the sources and the drains returning to an initial state (Rₒₙ) by exposing them to a light beam at a given wavelength.

**6.** Neural network circuit according to claim 4 or 5, **characterised in that** each means (31, 40) for preventing the electrical characteristics (R_{DS}) of the nanoscale devices (211-215, 411-415) from being modified further comprises a current comparator (20, 201, 202) forming part of the corresponding CMOS circuit, each current comparator comprising a first input (20a, 201 a, 202a) connected to the corresponding row conductor (22, 221-223), a second input (20b, 201 b, 202b) receiving a reference current (I_{ref}, I_{ref1}, I_{ref2}) and an output (20c, 201c, 202c) connected to the corresponding enabling row (40, 401, 402).

**7.** Neural network circuit according to any one of claims 1 to 6, **characterised in that** the CMOS circuits (20, 201, 202) form a first block (91) and the nanoscale devices (211-215, 411-415) form a second block (92), the first block (91) comprising a metal layer (914) serving as a substrate for the second block (92).

**8.** Neural network circuit according to claim 2 or 3, **characterised in that** the CMOS circuits (20, 201, 202) form a first block (91) and the nanoscale devices (211-215, 411-415) form a second block (92), the first block (91) comprising a metal layer (914) serving as a substrate for the second block (92), the metal layer (914) embodying the column conductors (231-234), the neural network circuit comprising a further metal layer (93) embodying the row conductors (221-223), the memristors (211-215) being grown at each intersection of a column conductor (231-234) and a row conductor (221-223).

**9.** Neural network circuit according to any one of claims 4 to 6, **characterised in that** the CMOS circuits (20, 201, 202) form a first block (91) and the nanoscale devices (211-215, 411-415) form a second block (92), the first block (91) comprising a metal layer (914) serving as a substrate for the second block (92), the metal layer (914) embodying the enabling rows (40, 401, 402), the neural network circuit further comprising two metal layers (915, 916), one of them embodying the row conductors (221-223) and the other the column conductors (231-234), the carbon nanotube field-effect transistors (411-415, 421-425) being implemented on the enabling rows (40, 401, 402) at each intersection of a row conductor (221-223) and a column conductor (231-234).

**10.** Neural network circuit according to claim 1, **characterised in that** each nanoscale device (211-215, 411-415) comprises a graphene based tunable resistance including two terminals, the terminals forming the first and second terminals of the nanoscale device.

**11.** Neural network circuit according to claim 1, **characterised in that** each nanoscale device (211-215, 411-415) comprises a nanoscale flash memory, a source and a drain of each nanoscale flash memory forming respectively the first and the second terminal of the considered nanoscale device, a resistance (R_{DS}) between the source and the drain being able to be modified by voltage pulses applied to the drain, the means (31, 40) for preventing the electrical characteristics (R_{DS}) of the nanoscale devices (211-215, 411-415) from being modified comprising as many enabling rows (40, 401, 402) as row conductors (22, 221-223), the gates of the nanoscale flash memories connected to a given row conductor (22, 221-223) being connected to an associated enabling row (40, 401, 402).

**12.** Neural network circuit according to claim 1, **characterised in that** each nanoscale device (211-215, 411-415) comprises a graphene based field-effect transistor, a source and a drain of each graphene based field-effect transistor forming respectively the first and the second terminal of the considered nanoscale device, a resistance (R_{DS}) between the source and the drain being able to be modified by voltage pulses applied to the drain, the means (31, 40) for preventing the electrical characteristics (R_{DS}) of the nanoscale devices (211-215, 411-415) from being modified comprising as many enabling rows (40, 401, 402) as row conductors (22, 221-223), the gates of the graphene based field-effect transistors connected to a given row conductor (22, 221-223) being connected to an associated enabling row (40, 401, 402).
